# EUROPEAN PATENT SPECIFICATION

(11) **EP 0 440 389 B1**
(45) Date of publication and mention of the grant of the patent: **16.03.1994**
(21) Application number: 91300613.6
(22) Date of filing: 28.01.1991
(51) Int. Cl.: H03L 7/099, H03L 7/181, H03K 3/03, H03L 7/183

(54) **Tuned ring oscillator and clock generation circuit provided therewith**
Abgestimmter Ringoszillator und zugehöriger Taktgenerator
Oscillateur en anneau accordé et circuit de génération d'horloge associé

(30) Priority: 02.02.1990 US 474183
(43) Date of publication of application: 07.08.1991
(73) Proprietor: SEAGATE TECHNOLOGY INTERNATIONAL, Georgetown, Grand Cayman Island (KY)
(72) Inventor: Lewis, David M., Santa Cruz, California 95062 (US)
(74) Representative: Miller, Joseph

(56) References cited:
- EP-A- 0 235 441
- WO-A-85/00941
- US-A- 4 103 251
- Introduction to VLSI Systems,section 7-4,pages 233-236,1980, Addison-Wesley Publishing, USA.

## Description

This invention relates to tuned ring oscillators and to clock generation circuits provided therewith.

The subject of clock generation for digital electronic circuits is covered in Section 7.4 "Clock Generation" of a book by Carver Mead and Lynn Conway entitled Introduction to VLSI Systems, Addison-Wesley, pages 233 to 236. Previously, the reference clock for operation of sub-systems was obtained from a master clock signal, itself obtained from a crystal or other resonant circuit. For a self-contained VLSI system on an integrated circuit chip, it is often essential that clock signals are generated on the chip. The book recommends that, instead of dealing with electronic oscillator circuits, it is better to take a more basic approach beginning with an understanding of what clock signals are used for. A fundamental principle is stated, which is that the role of the clock in a synchronous system is to connect a sequence of desired events with time. The interval between clock transitions must be sufficient to permit the activities planned for that interval to occur. A clock signal then is more like a set of timers than an oscillator.

Timers can be built as a chain of inverter circuits. Clock generation circuits that use timers are elaborations on a ring oscillator circuit, which has an odd number of signal inversions around the ring. The ring oscillator has period that is an odd sub-multiple of the delay time twice around the ring. To avoid having the ring oscillate at a harmonic, clock signals are suppressed during initialisation by using a gate in series with the ring to inhibit operation until an initialising signal is provided.

An example of such ring oscillators can be found in U.S. Patent 4103251.

The present invention seeks to provided a tuned ring oscillator circuit wherein a time reference signal is tuned to a variable system reference signal, such as the spindle index pulse of a magnetic disk drive.

According to one aspect of the present invention there is provided a tuned ring oscillator circuit comprising:
a ring oscillator;
means for interrupting said ring oscillator for a predetermined time including control gate means for inhibiting propagation of an oscillation signal through said ring oscillator, and having a control terminal for controlling propagation of said oscillation signals;
control means for providing control of the repetition rate of an output clock pulse;
comparison means for comparing the frequency of the output clock pulse with the frequency of a system reference pulse and for generating control signals for the control means to provide adjustment of the output clock pulse to tune the frequency of the ring oscillator to the frequency of the system reference pulse; characterised in that
said control means comprises a programmable frequency divider for providing coarse control said programmable divider having an input terminal coupled to said ring oscillator and an output terminal at which is provided the output clock pulse and programmable delay line means for providing fine control,
said programmable delay line means including delay time programming means for setting a delay time, said programmable delay line means having program input terminals for receiving said control signals, having an input terminal coupled to the output terminal of the programmable frequency divider means, and having an output terminal coupled to the control terminal of the control gate means;
in that said ring oscillator comprises a plurality of inverting stages connected in series in an oscillator ring;
and in that said control gate means is coupled in series with said plurality of inverting stages.

The comparison means may include a control micro-processor for generating the control signals for the programmable delay line means.

In one embodiment the comparison means includes means for measuring the frequency of the ring oscillator, including a counter activated to count the number of pulses from the tuned ring oscillator for a pre-determined period defined by the period of the system reference pulse wherein an information signal indicative of the number of counted pulses is provided to said control micro-processor.

In operation, the system reference pulse may be an index pulse for a rotating memory system.

In operation, the index pulse may be a spindle index pulse.

According to another aspect of the present invention there is provided a clock generation circuit for a magnetic storage disk controller characterised by comprising a tuned ring oscillator circuit according to the present invention.

The invention is illustrated, merely by way of example, in the accompanying drawings, in which:-
Figure 1 is a circuit diagram of a known ring oscillator;
Figure 2 is a logic circuit diagram of a tuned ring oscillator circuit according to the present invention;
Figures 3A and 3B are respective sets of waveform diagrams at various terminals in the circuit of Figure 2 for a short delay interval and for a longer delay interval; and
Figure 4 is a logic circuit diagram of a clock rate timer which performs a comparison between the frequency of the tuned ring oscillator and the frequency of a reference pulse.

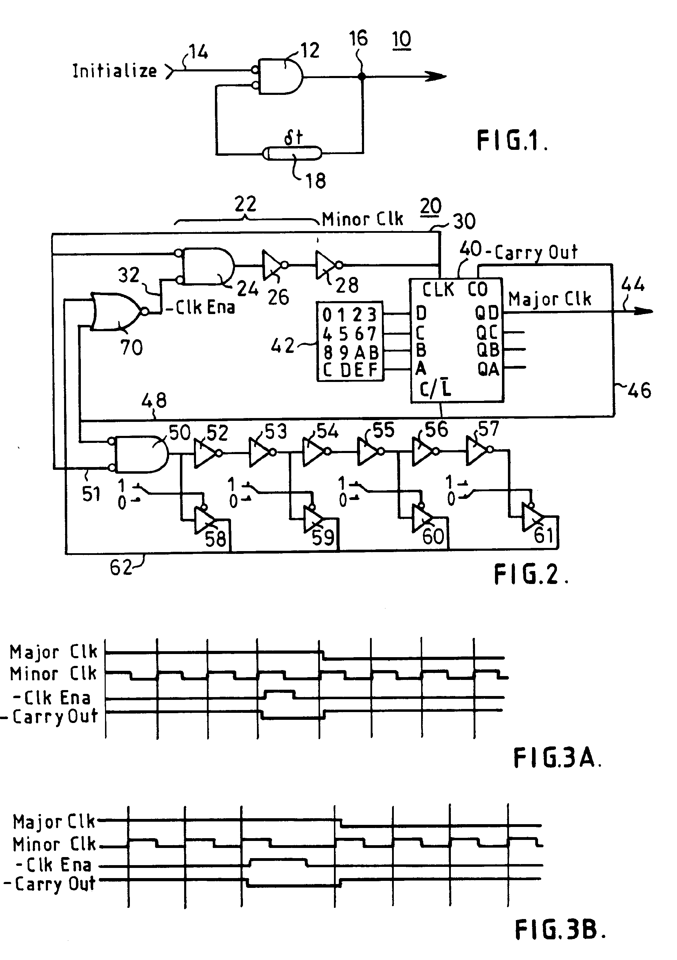

Figure 1 shows a known ring oscillator circuit 10. This simple version of a ring oscillator circuit includes an inverted-input AND gate 12, or inverter, which has an initialising signal present at a signal line 14 connected to one of the input terminals. The output signal for this circuit is provided at a terminal 16. The output signal is fed back through a delay device 18 to another input terminal of the inverted input AND gate 12, as shown.

Figure 2 shows a tuned ring oscillator circuit 20 according to to the present invention. A ring oscillator 22 includes a two input inverted input AND gate 24. The output terminal of the AND gate 24 is connected to the input terminal of a first inverter 26. The output terminal of the inverter 26 is connected in series to the input terminal of a second inverter 28. The output terminal of the second inverter 28 is fed back on the signal line 30 to one of the inverting input terminals of the AND gate 24. This forms an oscillator ring.

The AND gate 24 functions as an inverter and also provides a means for interrupting the ring oscillator 22 for a pre-determined time by inhibiting progagation of an oscillating signal through the ring oscillator 22. The AND gate 24 is disabled when a logical high signal level appears at the other input terminal to the AND gate 24, on a signal line 32.

The output signal of the ring oscillator 22 which appears on the signal line 30 is designated the Minor Clock signal. The signal appearing on the signal line 32 at the second input to the AND gate 24 is an inverted Clock Enable signal (-CLKENA). The Minor Clock signal is also connected to a clock input (CLK) of a programmable frequency divider 40 which is programmed by, for example, a key pad 42 which provides appropriate binary input signals to the programming terminals A, B, C, D of the divider 40. An inverted Carry Out CO signal is an active low signal. The divider 40 frequency divides the Minor Clock signal from the oscillator ring 22. Each period of the Minor Clock signal represents a clock increment of between 4 and 16 nano seconds. The output of the divider 40 is obtained as a Major Clock signal on a signal line 44 from an output terminal QD of the divider 40. The carry out signal CO is fed back on a signal line 46 to an inverted load terminal L̅. The Carry Out signal is also fed on a signal line 48 to one inverting input terminal of an inverting input AND gate 50. The other input terminal of the AND gate 50 is fed on the signal line 52 with the Minor Clock signal from the ring oscillator circuit 22. The output signal of the AND gate 50 is passed through a series of inverter pairs 52, 53; 54, 55; 56, 57 which are connected in series as shown. These inverter pairs form a delay line having delay increments of two gate delay times. The output signal from the AND gate 50 and each of the inverter pairs is provided to the respective input terminals of respective transmission gates 58, 59, 60, 61. These transmission gates are controlled by respective control signals at respective control terminals. These transmission gates 58, 59, 60, 61 provide taps for the delay line formed of the inverter pairs 52 to 57. The output signals of the transmission gates 58 to 61 are tied together and connected to a signal line 62.

A NOR gate 70 has the carry out signals CO connected to one input terminal and the output signal from the transmission gates 58 to 61 on the line 62 connected to its other input terminal. The input terminals to the NOR gate 70 are combined to provide the clock enable signal on the signal line 32.

Figure 3A shows the signal waveforms for the Major Clock signal, the Minor Clock signal, the inverted Clock Enable signal, and the negative Carry Out signal CO for the circuit of Figure 2 when a small time delay from the delay time formed by the inverter pairs 52 to 57 is obtained. The period of the Major Clock signal is thereby extended for a short period of time.

Figure 3B shows the Major Clock signal, the Minor Clock signal, the inverted Clock Enable signal, and the inverted Carry Out signal obtained for a long clock delay from the inverter pairs 52 to 57. The inverted Clock Enable signal is maintained at a high level in the long clock delay configuration which inhibits the ring oscillator 22 for a longer period of time. This extends the period of the Major Clock signal by adding the delay line of the inverter pairs 52 to 57 each time that the divider 40 overflows. The taps on the delay line constituted by the inverter pairs 52 to 57 are programmable with each tap representing one half to two nanoseconds. In this way the period of the Major Clock signal from the divider 40 on the signal line 44 is incremented in very small increments.

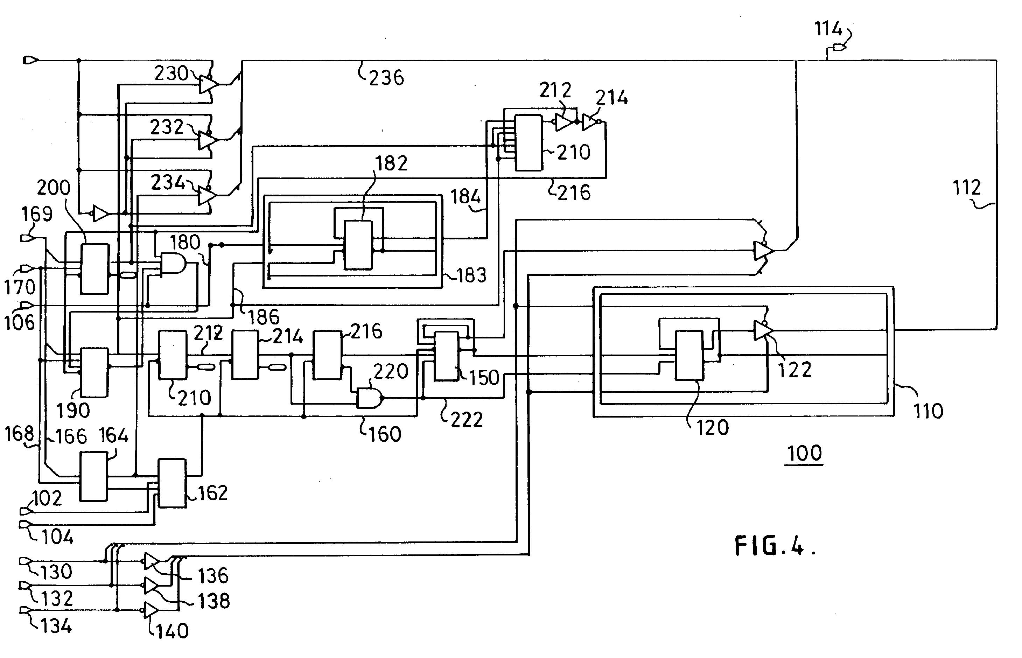

Figure 4 shows a logic circuit diagram of a clock rate timer circuit 100 for comparing the frequency of an input clock signal (DRAM_Clk or SCSI_Clk) obtained from the tuned ring oscillator circuit 20 with the frequency of a reference pulse signal (Index_Edge). The logic circuits are formed from standard cells and builing blocks provided from the AT&T 1.25 micron CMOS Library. The DRAM_Clk clock signal operates typically at frequencies in the range of 10 to 24 Mhz and is provided at an input terminal 102. The SCSI_Clk clock signal typically operates at 20 Mhz and is provided at an input terminal 104. The Index_Edge signal is provided at an input terminal 106 and is derived from the edge of the index pulse for a magnetic disk system. The frequency of the Index_Edge pulse signal is typically 1/60th of a second.

Generally, the function of the clock rate timer circuit 100 shown in Figure 4 is to provide a time period equal to sixteen periods of the Index_Edge pulse signal during which the time period of the DRAM_Clk or SCSI_Clk clock signals are counted to determine the frequency of the ring oscillator. These pulses are counted in a modular ripple counter provided by a series of twenty four counter modules, typically indicated as 110. The outputs of the counter modules are provided as the Up_Data_Out (7:0) on a signal bus 112. The respective signal lines of the output bus 112 are connected to respective terminals 114. These terminals provide the information bits to a micro-processor (not shown) which compares the count of the ripple counter during the 16 periods of the Index_Edge signal. If the count from the ripple counter is not within the range acceptable to the micro-processor, the control signals from the micro-processor to the tuned ring oscillator circuit 20 are changed. The twenty four bits from the ripple counter to the micro-processor are provided as three multiplex groups of eight bits at the terminals 114. The drawing notation in Figure 4 for a ripple counter module 110 is that each of the blocks 110 represents an I, where I = 1 to 23, module. The modules are arranged and interconnected to provide a ripple counter. Each of the modules 110 includes a D flip-flop 120 having its QN terminal connected to its D input terminal to function as a divide by two circuit. An input signal CNT_(I-1) is provided from a previous stage (I-1) as the input signal on the clock terminal CK for the Ith module. Each Q output of the D flip-flop 120 is provided through a transmission gate 122 to the output bus 112. The transmission gate 122 and similar transmission gates for the other modules of the ripple counter are controlled by counter read signals Rd_(2:0) and its inverted signal Rd_(2:0). Both the Rd_(2:0) signals and the non-inverted versions are obtained from signals presented on respective input terminals 130, 132, 134. These signals represent the three groups of multiplexed eight bit blocks for the twenty four bit output data word from the ripple counter. The inverted version of these three input signals are derived from Rd_High, Re_Mid, and Rd_Low using the respective inverters 136, 138, 140. This circuit configuration allows selected eight bit blocks of information from the ripple counter to be read out onto the output bus 112.

Note that the ripple counter contains twenty four divide-by-two stages. The first stage of the ripple counter is the CNT_0 stage 150 which is also a D flip-flop divider. The inverted output signal QN of the D flip-flop 150 is fed to the clock terminal of the first stage (D flip-flop 120) of the ripple counter. The input signal to the clock terminal CK of the stage 150 is obtained on a signal line 160 from the output terminal of a selector 162. The selector 162 selects either the DRAM_Clk signal or the SCSI_Clk signal as determined by a selector D flip-flop 164 having its Q and QN inputs respectively coupled to the inputs of the selector stage 162. The D flip-flop 164 is switched to select one of the clocks by the bit two line of the three bit data selection signal present on a signal line 166. The clock signal presented to the CK terminal of the D flip-flop 164 is obtained on a signal line 168 from a write control terminal (Wr_Control) 170.

Selection of the operating mode of the clock rate timer circuit 100 is obtained using a control signal obtained from the micro-processor. That signal is an Up_Data_In (2:0) signal, which is provided on three signal lines coupled to terminals 169.

A counter for counting the pulses of the Index_Edge signal, that is the Indx_(0) signal, is provided at a terminal 106 to a signal line 180 and to a clock CK terminal of a first D flip-flop 182, which is the first divide by two stage of a five stage index counter for counting index pulses. Similar to the ripple counter module 110, the five stage index counter comprises five D flip-flop stages 183, as indicated in Figure 4, with appropriate connections being made for the four other stages. The output of the five stage counter is the Indx_(5) signal which is provided on a signal line 182. The five stage index pulse counter is activated by a Run signal provided on the signal line 186 connected to the negative clear CDN terminal of the first stage 182. The Run signal is provided on the signal line 186 from the Q output terminal of a run flip-flop stage 190. The run flip-flop stage 190 has a clock signal provided at its clock terminal CK from the Wr_Control terminal 170. An input signal to the D terminal of the run flip-flop stage 190 is obtained from the zero bit of the UP_Data_In (2:0) signals.

A time index flip-flop 200 is alternatively provided such that the next stage of the Index_Edge signal sets the run flip-flop stage 190 and starts the ripple index counter for counting the index pulses into operation. The index counter for the index pulses counts typically to sixteen.

When the index counter counts to sixteen, a signal present on a signal arm 184 at the output of the ripple counter is progagated through a selector 210 and two inverting stages 212, 214 to a signal line 216. This signal is called the stop signal which re-sets the alternate time index flip-flop 200 and the run flip-flop stage 190 to zero output signal levels. Note that for the selector 210 when the time index pulse, the run pulse and the Index_(5) are all true, the stop signal on the signal line 216 is also in a true state.

The run signal present on the signal line 186 also is connected to the input of a first D flip-flop Syn0 210 of a D flip-flop 210, the Q output of which is coupled through a signal line 212 to the D input of a second D flip-flop Syn1 214. An edge D flip-flop 216 is also provided. Both the D flip-flops Syn0 and Syn1, and the edge flip-flop 216 all have their respective clock terminals CK connected to the output terminal of the selector 162 which selects either the DRAM_Clk or the SCSI_Clk signals. The clock terminal is provided on a signal line 160 to the clock CK terminal of the first stage 150 of the ripple counter. The synchronised signal provided by the D flip-flop Syn1 of the synchroniser and the edge flip-flop 216 both provide respective inputs to an AND gate 220. The output of the AND gate 220 provides a pre-set signal on a signal line 222 to PO terminals respectively of all of the stages of the ripple counter, as indicated, to get all stages to a one level.

The status of the Q output signals of the time index flip-flop 200, the run flip-flop stage 190, and the selector D flip-flop 162 are provided through respective transmission gates 230, 232, 234 on a signal bus 236 to the output bus 112 and from thence to the respective output terminals 114 of the micro-processor.

The clock rate timer circuit shown in Figure 4 permits the micro-processor to control the frequency of the tuned ring oscillator circuit 20 as shown in Figure 2. This is accomplished by the index ripple counter counting sixteen index pulses to provide a count period for the clock pulse ripple counter. This permits the frequency of the tuned ring oscillator circuit 20 to be synchronised to the index pulse and tends to remove long term variations caused by temperature changes, voltage changes, and variations in semi-conductor process parameters.

## Claims

1. A tuned ring oscillator circuit comprising:
a ring oscillator (22);
means for interrupting said ring oscillator for a predetermined time including control gate means (24, 70) for inhibiting propagation of an oscillation signal through said ring oscillator, and having a control terminal for controlling propagation of said oscillation signals;
control means (40, 52-57) for providing control of the repetition rate of an output clock pulse;
comparison means (100) for comparing the frequency of the output clock pulse with the frequency of a system reference pulse and for generating control signals for the control means (52 to 57) to provide adjustment of the output clock pulse to tune the frequency of the ring oscillator (22) to the frequency of the system reference pulse; characterised in that
said control means comprises a programmable frequency divider (40) for providing coarse control said programmable divider having an input terminal coupled to said ring oscillator and an output terminal at which is provided the output clock pulse and programmable delay line means (52, 57) for providing fine control,
said programmable delay line means including delay time programming means (58 to 61) for setting a delay time, said programmable delay line means having program input terminals for receiving said control signals, having an input terminal coupled to the output terminal of the programmable frequency divider means (40), and having an output terminal coupled to the control terminal of the control gate means (24, 70);
in that said ring oscillator comprises a plurality of inverting stages (26, 28) connected in series in an oscillator ring;
and in that said control gate means is coupled in series with said plurality of inverting stages

2. A tuned ring oscillator as claimed in claim 1 in which the comparison means (100) includes a control micro-processor for generating the control signals for the programmable delay line means (52 to 57).

3. A tuned ring oscillator as claimed in claim 2, in which the comparison means (100) includes means for measuring the frequency of the ring oscillator (22), including a counter (110) activated to count the number of pulses from the tuned ring oscillator for a pre-determined period defined by the period of the system reference pulse wherein an information signal indicative of the number of counted pulses is provided to said control micro-processor.

4. A tuned ring oscillator as claimed in any preceding claims, in which, in operation, the system reference pulse is an index pulse for a rotating memory system.

5. A tuned ring oscillator as claimed in claim 4, in which, in operation, the index pulse is a spindle index pulse.

6. A clock generation circuit for a magnetic storage disk controller, characterised by comprising a tuned ring oscillator circuit as claimed in any preceding claim.

## Patentansprüche

1. Abgestimmte Ringoszillatorschaltung mit:
einem Ringoszillator (22)
Einrichtungen zur Unterbrechung des Ringoszillators für eine vorgegebene Zeit, unter Einschluß von Steuer-Verknüpfungsglied-Einrichtungen (24, 70) zum Sperren der Ausbreitung eines Oszillatorsignals durch den Ringoszillator und mit einem Steueranschluß zur Steuerung der Ausbreitung der Oszillatorsignale,
einer Steuereinrichtung (40, 52-57) zur Erzielung einer Steuerung der Wiederholfrequenz eines Ausgangstaktimpulses,
einer Vergleichereinrichtung (100) zum Vergleich der Frequenz des Ausgangstaktimpulses mit der Frequenz eines Systembezugsimpulses und zur Erzeugung von Steuersignalen für die Steuereinrichtung (52-57) zur Erzielung einer Einstellung des Ausgangstaktimpulses zur Abstimmung der Frequenz des Ringoszillators (22) auf die Frequenz des Systembezugsimpulses, dadurch gekennzeichnet, daß
die Steuereinrichtung einen programmierbaren Frequenzteiler (40) zur Erzielung einer Grobsteuerung, wobei der programmierbare Teiler einen mit dem Ringoszillator gekoppelten Eingangsanschluß und einen Ausgangsanschluß aufweist, an dem der Ausgangstaktimpuls geliefert wird, und eine programmierbare Verzögerungsleitungseinrichtung (52, 57) zur Erzielung einer Feinsteuerung umfaßt,
die programmierbare Verzögerungsleitungseinrichtung Verzögerungszeit-Programmierereinrichtungen (58-61) zur Einstellung einer Verzögerungszeit einschließt, wobei die programmierbare Verzögerungsleitungseinrichtung Programm-Eingangsanschlüsse zum Empfang der Steuersignale, einen mit dem Ausgangsanschluß der programmierbaren Frequenzteilereinrichtung (40) gekoppelten Eingangsanschluß und einen Ausgangsanschluß aufweist, der mit dem Steueranschluß der Steuer-Verknüpfungsglied-Einrichtung (24, 70) gekoppelt ist,
der Ringoszillator eine Vielzahl von in Serie in einem Oszillatorring geschalteten Inverterstufen (26, 28) umfaßt, und
die Steuer-Verknüpfungsglied-Einrichtung in Serie mit der Vielzahl von Inverterstufen geschaltet ist.

2. Abgestimmter Ringoszillator nach Anspruch 1, bei dem die Vergleichereinrichtung (100) einen Steuer-Mikroprozessor zur Erzeugung der Steuersignale für die programmierbare Verzögerungsleitungseinrichtung (52-57) einschließt.

3. Abgestimmter Ringoszillator nach Anspruch 2, bei dem die Vergleichereinrichtung (100) Einrichtungen zur Messung der Frequenz des Ringoszillators (22) einschließt, die einen Zähler (110) einschließen, der aktiviert wird, um die Anzahl der Impulse von dem abgestimmten Ringoszillator für eine vorgegebene Periode zu zählen, die durch die Periode des Systembezugsimpulses definiert ist, wobei ein die Anzahl der gezählten Impulse anzeigendes Informationssignal an den Steuer-Mikroprozessor geliefert wird.

4. Abgestimmter Ringoszillator nach einem der vorhergehenden Ansprüche, bei dem im Betrieb der Systembezugsimpuls ein Indeximpuls für ein rotierendes Speichersystem ist.

5. Abgestimmter Ringoszillator nach Anspruch 4, bei dem im Betrieb der Indeximpuls ein Spindelindeximpuls ist.

6. Taktgeneratorschaltung für ein Magnetplattenspeicher-Steuergerät,
dadurch gekennzeichnet, daß sie einen abgestimmten Ringoszillator nach einem der vorhergehenden Ansprüche umfaßt.

## Revendications

1. Circuit oscillateur en anneau accordé comprenant :
un oscillateur en anneau (22) ;
des moyens pour interrompre ledit oscillateur en anneau pendant un temps prédéterminé, comprenant des moyens (24, 70) formant porte de commande pour inhiber la propagation d'un signal d'oscillation dans ledit oscillateur en anneau et ayant une borne de commande servant à commander la propagation desdits signaux d'oscillation ;
des moyens de commande (40, 52 à 57) servant à assurer la commande de la fréquence de répétition d'une impulsion d'horloge de sortie ;
des moyens de comparaison (100) servant à comparer la fréquence de l'impulsion d'horloge de sortie à la fréquence d'une impulsion de référence du système et à engendrer des signaux de commande pour les moyens de commande (52 à 57) pour assurer l'ajustement de l'impulsion d'horloge de sortie de manière à accorder la fréquence de l'oscillateur en anneau (22) à la fréquence de l'impulsion de référence du système, caractérisé en ce que :
lesdits moyens de commande comprennent un diviseur de fréquence programmable (40) servant à assurer un réglage grossier, ledit diviseur programmable ayant un borne d'entrée couplée audit oscillateur en anneau et une borne de sortie à laquelle apparaît l'impulsion d'horloge de sortie et des moyens formant ligne à retard programmable (52 à 57), servant à assurer un réglage fin,
lesdits moyens formant ligne à retard programmable comprenant des moyens de programmation du temps de retard (58 à 61) servant à fixer un temps de retard, lesdits moyens formant ligne à retard programmable possédant des bornes d'entrée de programme pour recevoir lesdits signaux de commande, ayant une borne d'entrée couplée à la borne de sortie des moyens formant division de fréquence programmable (40), et ayant une borne de sortie couplée à la borne de commande des moyens formant porte de commande (24, 70) ;
ledit oscillateur en anneau comprend une pluralité d'étages inverseurs (26, 28) connectés en série dans un anneau d'oscillateur ;
et que lesdits moyens formant porte de commande sont couplés en série avec ladite pluralité d'étages inverseurs.

2. Oscillateur en anneau accordé selon la revendication 1, dans lequel les moyens de comparaison (100) comprennent un microprocesseur de commande servant à engendrer les signaux de commande pour les moyens formant ligne à retard programmable (52 à 57).

3. Oscillateur en anneau accordé selon la revendication 2, dans lequel les moyens de comparaison (100) comprennent des moyens servant à mesurer la fréquence de l'oscillateur en anneau (22), comprenant un compteur (110) activé pour compter le nombre d'impulsions issues de l'oscillateur en anneau accordé pendant une période prédéterminée définie par la période de l'impulsion de référence du système, dans lequel un signal d'information indicatif du nombre d'impulsions comptées est transmis audit microprocesseur de commande.

4. Oscillateur en anneau accordé selon l'une quelconque des revendications précédentes, dans lequel, en fonctionnement, l'impulsion de référence du système est une impulsion index pour un système de mémoire rotatif.

5. Oscillateur en anneau accordé selon la revendication 4, dans lequel, en fonctionnement, l'impulsion index est une impulsion index de broche.

6. Circuit de génération d'horloge pour un contrôleur de disque de mémoire magnétique, caractérisé en ce qu'il comprend un circuit oscillateur en anneau accordé selon l'une quelconque des revendications précédentes.
